# EUROPEAN PATENT APPLICATION

(11) **EP 4 707 819 A1**
(43) Date of publication of application: **11.03.2026**
(21) Application number: 25199029.7
(22) Date of filing: 29.08.2025
(51) Int. Cl.: G01R 1/067, G01R 1/22

(54) **NON-INVASIVE WIRE TESTING DEVICE**

(30) Priority: 30.08.2024 US 202463689359 P
(71) Applicant: Horizon Global Americas Inc., Cleveland, OH 44114 (US)
(72) Inventor: GUTHARD, Henry J., Livonia, 48154 (US); ELLIOTT, William, Topeka, 66618 (US); DeLUCCO, Damien, Wamego, 66547 (US); BLALOCK, William K., Emporia, 66801 (US)
(74) Representative: Ungria López, Javier

(57) **Abstract**

A non-invasive wire testing device includes a handle portion having a jaw assembly. The jaw assembly has a fixed jaw with a U-shaped ferrite defining a channel, and a pivot jaw with a ferrite block rotatably coupled to the handle portion. The pivot jaw selectively rotates to and from the fixed jaw to enclose the channel or open the channel for receiving a wire. In a closed position, the ferrite block moves against the U-shaped ferrite to form a magnetic loop surrounding the opening. The magnetic loop magnifies a magnetic field from current in the wire for reading by a Hall effect sensor. Circuitry connected to the Hall effect sensor generates a signal indicative of the measured current.

## Description

### CROSS-REFERENCE TO RELATED APPLICATION

This application claims priority to U.S. Provisional Patent Application No. 63/689,359, filed August 30, 2024 which is incorporated herein by reference.

### BACKGROUND OF THE INVENTION

### 1. Field of the Invention

The subject disclosure relates generally to wire-testing devices, and more particularly to non-invasive wire testing devices for use with vehicle wiring systems.

### 2. Background of the Related Art

In recent years, vehicle technology has rapidly progressed. Vehicles today often possess numerous on-board computers, sensors, lights, cameras, screens, electronic control units, batteries, actuators, and other implements that are controlled electronically. This means that thousands of wires connect practically every part of a vehicle. To further complicate this, wires of varying types are often coupled together by wiring harnesses to save space and reduce the likelihood that one wire may become separated and damaged.

This increased complexity of vehicles has made the installation of aftermarket parts much more complicated. For example, many drivers benefit from the use of a trailer. Oftentimes, especially with the purchase of a large vehicle such as a truck or SUV, there is an existing electrical interface for the trailer or other towing connections. This electrical interface is hard-wired into the vehicle's electrical system. When plugged into a trailer, the electrical interface provides brake lights, turn signals, reverse lights, and driving lights to the trailer, so that the driver may remain safe and visible on the road. However, for vehicles that do not come with an existing electrical interface, aftermarket installation is required.

Aftermarket installation of an electrical interface requires that a user find each specific wire that controls a function of the vehicle and connect it to the corresponding spot on the electrical interface. This requires some form of a wire tester, which can test to see if a wire has an electrical current flowing through it. For example, to see if a certain wire on the vehicle controls the brakes, a user will need to press the brake and use a wire tester to see if a current is flowing through the wire in question. There are several forms of wire tester that can be used for this.

One method of testing whether a wire has current flowing through it involves directly accessing and testing the wire. This can be done by piercing the insulation with a sharp probe or needle-tip multimeter, or by splicing or cutting the insulation to expose the conductor. However, this is considered highly invasive and can cause long-term damage and reliability issues with the wire such as corrosion, insulation issues, and even an increased risk of electrical fires. Although many still utilize these methods, non-invasive wire testing devices have become the industry standard.

Non-invasive wire testing devices allow a user to test the current within a wire without accessing the wire's interior. There are several options in this space including clamp meters, non-contact voltage testers, and the like.

Non-contact voltage testers utilize capacitive coupling to detect the presence of a current within a wire. When using a non-contact voltage tester, a user can simply touch the tester to the insulation of a wire and detect whether or not there is a current flowing through the wire. However, non-contact voltage testers suffer several drawbacks, namely that they can only detect AC current. In the context of automotive applications, they are unable to detect most electrical currents within the vehicle because vehicles primarily use DC current (i.e., current flowing directly from the battery) to power things like lights, audio systems, and the like. Non-contact voltage testers are also highly susceptible to false positives and are generally not able to detect the magnitude of electrical current. Thus, many users choose ferrite-based clamp meters for wire testing in automotive applications.

Clamp meters provide a non-invasive way to measure electrical current in a wire. They typically use a ferrite core that surrounds the wire when the clamp is closed. The core concentrates the magnetic field generated by the current and directs it to a sensor, allowing the meter to detect and measure the current. Some models can also measure voltage.

However, clamp meters have several drawbacks. Their readings can vary due to factors like improper clamping and inconsistencies in internal structures, which are often foam-based. They can also be difficult to move from wire to wire and may struggle to accommodate different wire sizes.

There is a need for a ferrite-based, non-invasive wire tester that provides consistent, accurate readings across various wire shapes and sizes and can be easily moved from wire to wire.

### SUMMARY OF THE INVENTION

In view of the above, a need exists for a device that quickly and easily tests for the presence of a current within a wire. The improved device would also allow for the test to be performed non-invasively.

It should be appreciated that the subject technology can be implemented and utilized in numerous ways, including without limitation as a process, an apparatus, a system, a device, a method for applications now known and later developed. These and other unique features of the system disclosed herein will become more readily apparent from the following description and the accompanying drawings.

### BRIEF DESCRIPTION OF THE DRAWINGS

So that those having ordinary skill in the art to which the disclosed technology appertains will more readily understand how to make and use the same, reference may be had to the following drawings.
Figure 1 is a front perspective view of the non-invasive wire testing device of the present disclosure in a closed position.
Figure 2 is a side view of the non-invasive wire testing device of the present disclosure in a closed position.
Figure 3 is an exploded view of the non-invasive wire testing device of the present disclosure.
Figure 4 is a side cross-sectional view of the non-invasive wire testing device of the present disclosure.
Figure 5 is an exploded view of the PCB assembly of the non-invasive wire testing device.
Figure 6A is a lower assembled view of the trigger assembly of the non-invasive wire testing device.
Figure 6B is an exploded top perspective view of the trigger assembly of the non-invasive wire testing device.
Figure 6C is an exploded bottom perspective view of the trigger assembly of the non-invasive wire testing device.
Figure 6D is a side view of the trigger assembly with the cover removed in accordance with the subject disclosure.
Figure 7 is a perspective view of the non-invasive wire testing device in use.
Figure 8 is a troubleshooting chart for use with the non-invasive wire testing device.
Figure 9 is a quick reference guide for the LEDs of the non-invasive wire testing device.
Figure 10 is a chart with examples of multiplexed signals from the LEDs of the non-invasive wire testing device.
Figure 11 illustrates a correct orientation of the non-invasive wire testing device in use.

### DETAILED DESCRIPTION OF PREFERRED EMBODIMENTS

The subject technology overcomes many of the prior art problems associated with testing the flow of electrical current through wires. The advantages, and other features of the technology disclosed herein, will become more readily apparent to those having ordinary skill in the art from the following detailed description of certain preferred embodiments taken in conjunction with the drawings which set forth representative embodiments of the present technology and wherein like reference numerals identify similar structural elements. Directional indications such as upward, downward, right, left, proximal, distal, and the like are used with respect to the figures and not meant in a limiting manner.

In brief overview, the subject technology is directed to a device configured to test electrical current flow within a wire. The testing device is handheld and/or hand operated having the general appearance of pliers or a similar type of tool. The testing device can reliably, quickly and easily determine, without being invasive, if current flows through a variety of different size wires and electrical harnesses.

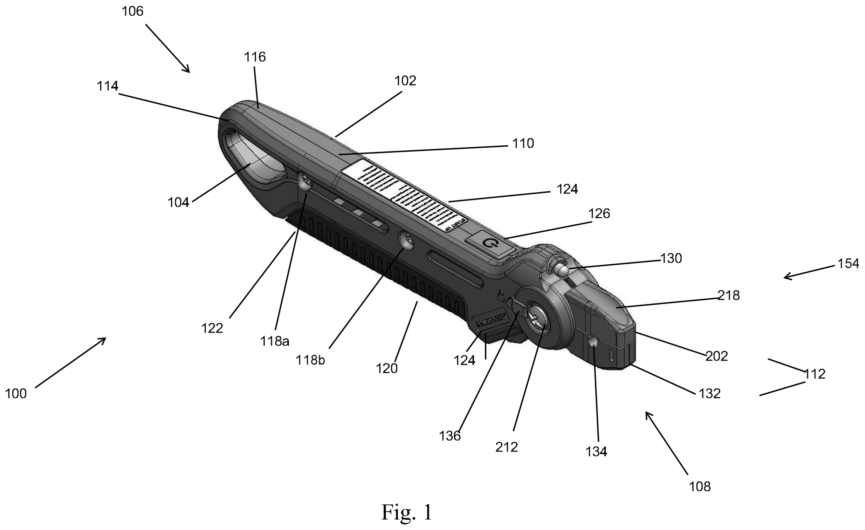

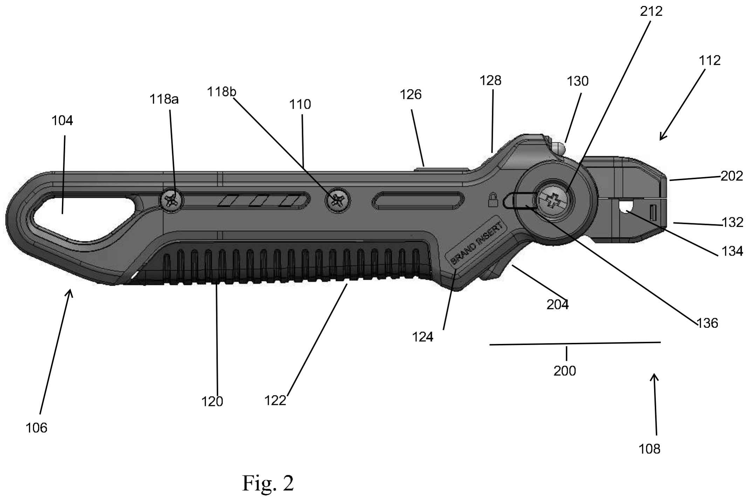

**Referring now to** **Figures 1** **and** **2****,** a perspective view and a side view of the device 100 are shown. The device 100 includes a body 102 that defines a clip hole 104 at a proximal end 106. The clip hole 104 is configured for ease of attaching the device 100 to a clip, a tool belt, or the like.

The body 102 also has a central handle portion 110 for gripping by a user. The central handle portion 110 extends from the clip hole 104 to a jaw assembly 112 at a distal end 108. The handle portion 110 has a left half 114 and a right half 116 secured together by screws 118a, 118b.

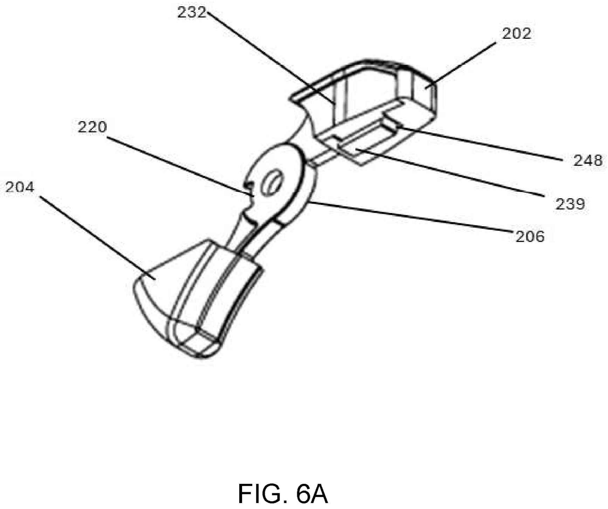

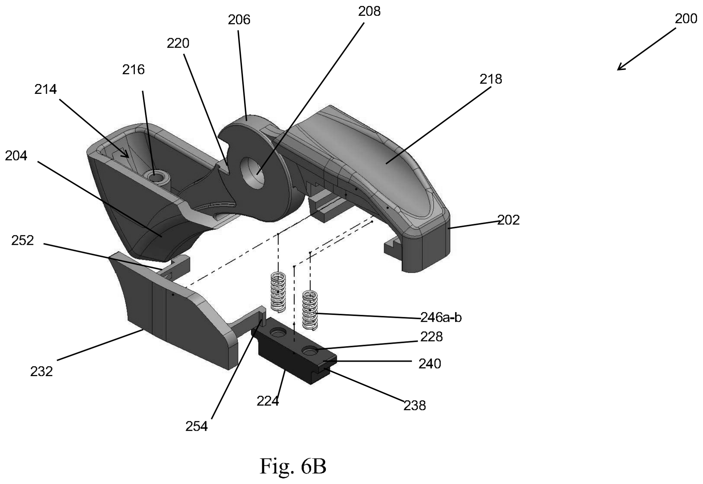

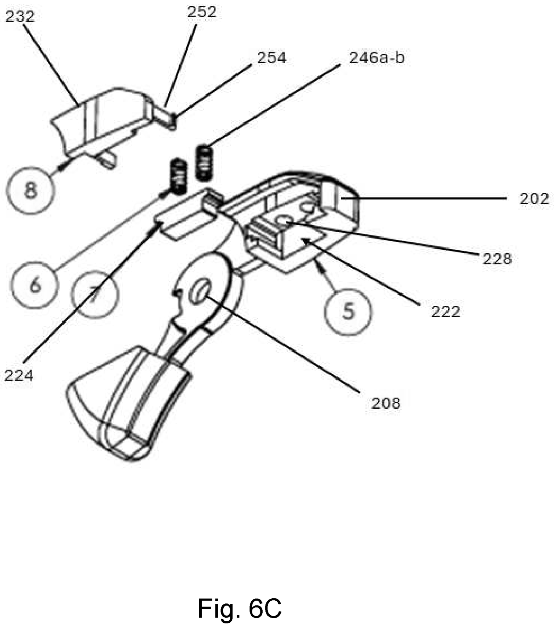

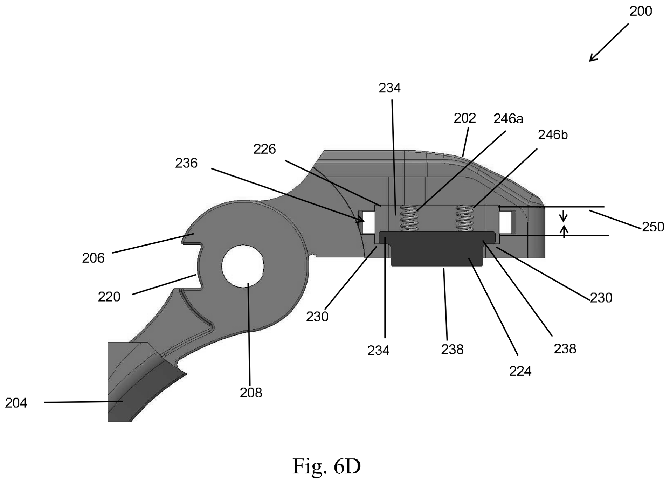

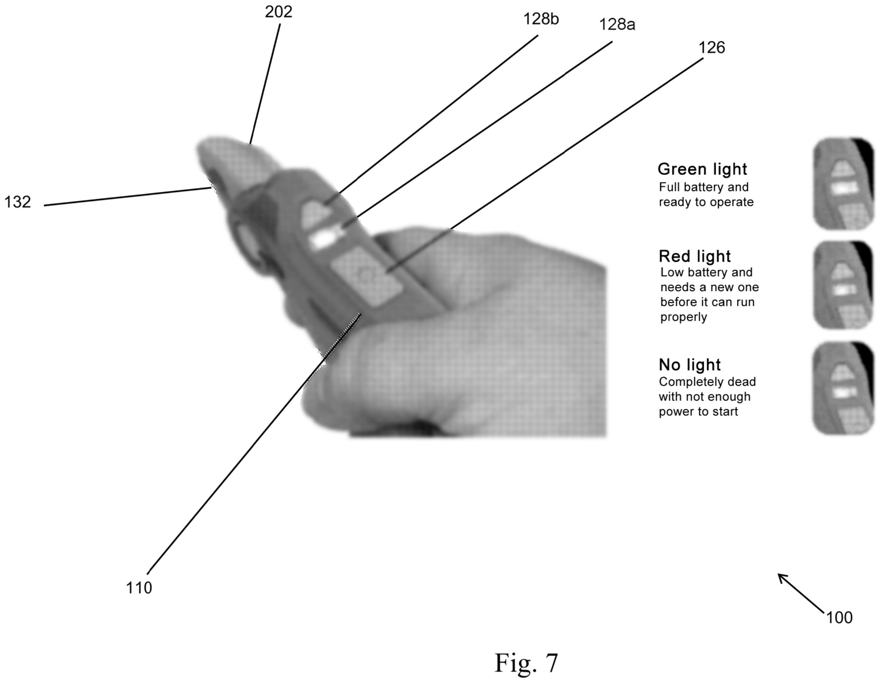

The handle portion 110 includes a snap-fit battery compartment door 120 with a tactile surface 122. The tactile surface 122 makes it easier for a user to grip or see the handle portion 110. The handle portion 110 has indicia 124 where a trademark and other company or kit information may be located. The indicia 124 also provide operational instructions, a model number, and a service and/or assistance telephone number. The handle portion 110 also includes a power button 126, and LED assembly 128, i.e., LED 1, 128a and LED 2, 128b (best seen in Figure 6), and a flashlight 130 to be used during operation of the device 100, as described below with relation to Figure 7.

The jaw assembly 112 includes a fixed jaw 132 extending from the distal end 108 of the handle portion 110. The fixed jaw 132 defines a channel 134 to receive a wire (not shown). The jaw assembly 112 further comprises a trigger assembly 200 rotatably coupled to the handle portion 110. The handle portion 110 includes a pivot joint lock 136 which locks the trigger assembly 200 into place for ease of storage or transport. The pivot joint lock 136 is manually moved against the trigger assembly 200 to fix the jaw assembly 112 in the closed position shown. For operation, the pivot joint lock 136 is simply manually pushed away from the pivot joint 138.

The trigger assembly 200 has a distal pivot jaw 202 which opposes the fixed jaw 132 to enclose the channel 134. The distal pivot jaw 202 is moved by manually actuating a trigger 204 as described below.

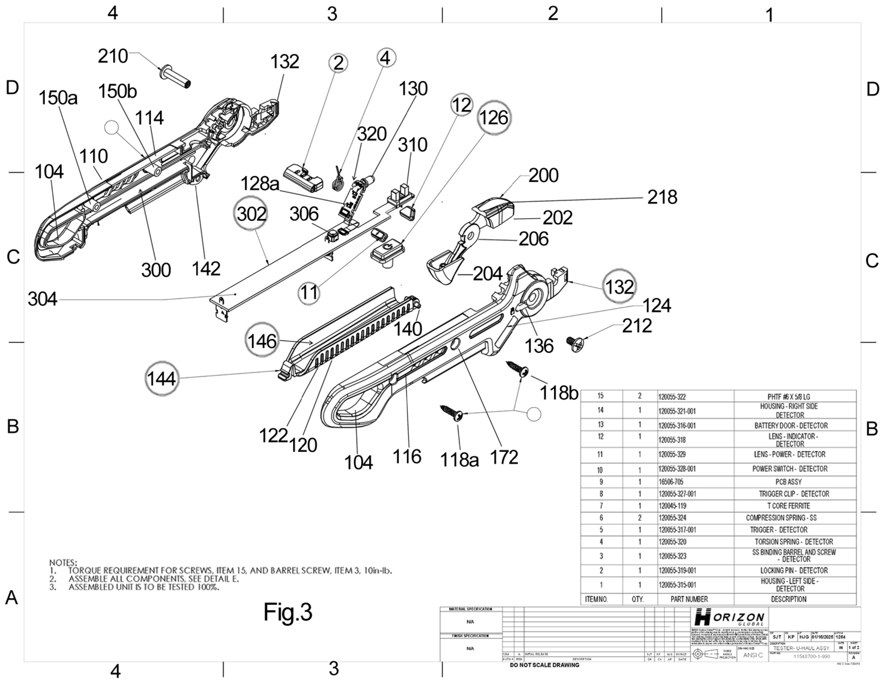

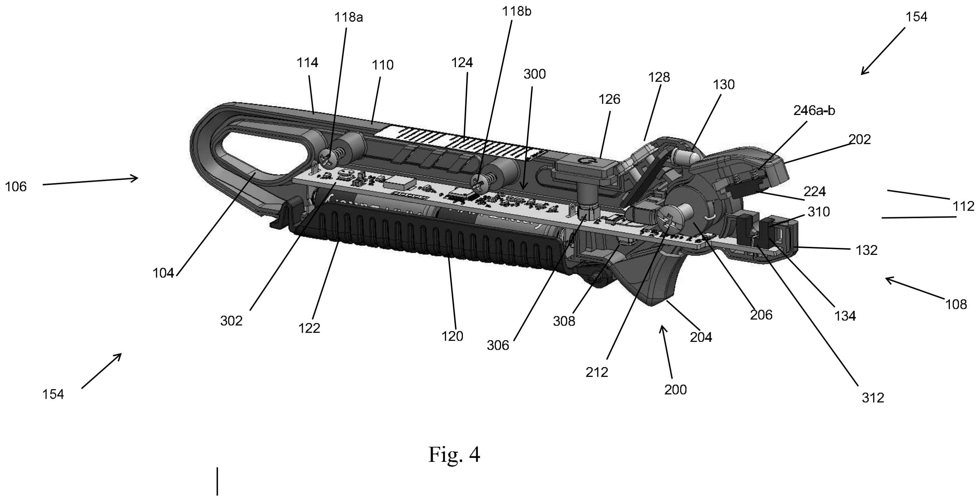

**Referring now to** **Figures 3** **and** **4****,** an exploded view and a cross-sectional view of the device 100 are shown. The body 102 has a right half 116 and a left half 114 that couple together to define an internal area 300. The halves 114, 116, also form hinge hole 142 for rotatably capturing the battery compartment door 120. The battery compartment door 120 has a hinge 140 that seats in the hinge hole 142 and an opposing snap tab 144 to access a battery area 146 for housing batteries (not shown) used to power operation of the device 100. The screws 118a, 118b pass through bores 172 in the right half 116 to secure into threaded posts 150a, 150b, respectively. The battery area 146 also includes a fuse (not shown) to be used in operation of the device 100. The fuse may be a fast-blow fuse or a slow-blow fuse and is located below the PCB assembly 302 for easy access by a user.

The internal area 300 houses a PCB assembly 302 including a PCB 304 with a first power switch (SW1) 306. SW1 306 operatively connects to the power button 126 on the handle portion 110 of the device 100. The flashlight 130 and LED assembly 128 are also electrically connected to the PCB assembly 302. The flashlight 130 and LED assembly 128 includes two LEDs 128a, 128b and a bulb 148. The flashlight 130 is operatively connected to a second power switch (SW2) 308, which is described in greater detail below.

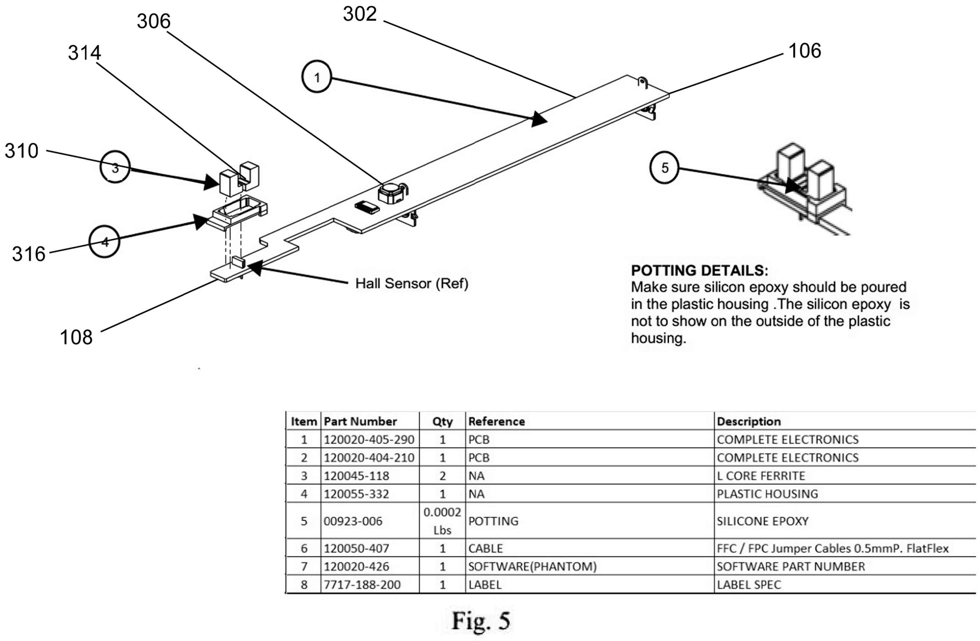

**Referring additionally to** **Figure 5****,** a simplified, exploded view of the PCB assembly 302 is shown. The PCB assembly 302 includes a U-shaped ferrite 310 and a Hall effect sensor 312 mounted at a distal end 108. A ferrite housing 316 at the distal end 108 of the PCB assembly 302 holds the U-shaped ferrite 310 in place. A slot 314 is located within the U-shaped ferrite 310 for holding the Hall effect sensor 312 in place. Optionally, filling the housing 316 with epoxy (not shown) secures the U-shaped ferrite 310 and the Hall effect sensor 312 to the PCB assembly 302.

Referring specifically to Figure 4, the PCB assembly 302 is housed within the internal area 300, extending into the fixed jaw 132. The U-shaped ferrite 310 defines a channel 134 at the distal end 108. The Hall effect sensor 312 couples to at least one of the fixed jaw 132 and the trigger assembly 200. The circuitry 318 operatively interconnects the Hall effect sensor 312, the power button 126, and the flashlight PCB 320, allowing for selective activation.

**Still referring to** **Figures 3-4** **and 6A,** the trigger assembly 200 has a pivot joint 138 formed by a hub 206 with a central hole 208 for receiving the threaded insert 210. The machined screw 212 holds the threaded insert 210 fixed in place.

A pivot jaw 202 and a trigger 204, extend from the pivot joint 138. The trigger 204 is configured for actuation by a user. The pivot jaw 202 is positioned at the distal end 108 of the device 100. A spring cavity 214 within the trigger 204 houses a spring guide 216 and a coil spring (not shown) on the spring guide 216 for biasing the trigger 204. Squeezing the trigger 204 towards the interior of the device 100 creates a lever action pivoting on the threaded insert that causes the pivot jaw 202 to move toward the fixed jaw 132 when the pivot joint lock 136 is in the unlocked position. In alternative embodiments, the device 100 rests in a closed position and actuation of the trigger 204 causes the pivot jaw 202 to move away from the fixed jaw 132.

The pivot jaw 202 includes a valley 218 on a top side for passing a focused beam of light from the flashlight 130. The pivot joint 138 includes a pivot joint lock 136 (See also Figures 1-2) seated within a detent 220, allowing the pivot joint lock 136 to rotate about the pivot joint 138 and lock or unlock the pivot joint 138.

**Referring to** **Figures 6A**-D**,** a lower assembled view and exploded views of the trigger assembly 200 are shown. The pivot jaw 202 forms a ferrite block area 222 that is a complimentary shape to the T-shaped ferrite block 224. The ferrite block area 222 is bound by an upper stop surface 226 with two spring recesses 228, lower stop shoulders 230, and an opposing sidewall cover 232. Opposing lower stop shoulders 230 of the pivot jaw 202 form a lower passage 248 of the ferrite block area 222. Sidewalls 234 extend between the upper stop surface 226 and lower shoulders 230 to form latch finger channels 236.

The ferrite block 224 has radial ears 238, to form the T-shape. A lower surface 239 opposes an upper surface 240 that form spring recesses 228a, 228b. The spring recesses 228a, 228b on the upper surface of the ferrite block 240 align with corresponding spring recesses 242a, 242b on the pivot jaw's upper stop surface 244.

When assembled, a pair of springs 246a, 246b extend between and sit within the respective recesses 228a-b and 242a-b. As a result, the ferrite block 224 is biased so that the radial ears 238 rest against the lower stop shoulders 230 and the lower surface 239 extends out of the lower passage 248 (best seen in Fig. 6A). The spring-loaded configuration allows the ferrite block 224 to slide within the ferrite block area 222. The ferrite block 224 can slide into the ferrite block area 222 along a defined range of travel 250 until the radial ears 238 contact the upper stop surface 226.

The ferrite block 224 is held laterally in the area 222 by a sidewall cover 232. The sidewall cover 232 has flexible fingers 252 with distal latches 254 for securing the sidewall cover 232 to the pivot jaw 202 and enclosing the ferrite block area 222. To assemble, the latch fingers 252 slide into the opposing channels 236 of the ferrite block area 222 so that the distal latches 254 engage with latch receiving voids (not shown) within the pivot jaw 202 to keep the opposing sidewall cover 232 and, in turn, the T-shaped ferrite block 224 in position.

The hub 206 includes a detent 220 in which the pivot joint lock 136 selectively engages. The pivot joint lock 136 rotates about the pivot joint 138 within the detent 220 to lock or unlock the pivot joint 202. The detent 220 is located on a side of the pivot joint 138 facing the user for ease of actuation. This configuration allows a user to deploy the pivot joint lock 136 into the detent 220 to facilitate one hand operation of the device 100.

Instead of the springs 246a-b shown at Figures 6A-6C, the device 100 may optionally utilize a single spring (not pictured). The single spring may be glued or otherwise secured to the upper stop surface 226 and the top of the ferrite block 224. Alternatively, the springs 246a-b may be replaced with a foam block (not pictured), one or more leaf springs (not pictured), one or more rubber springs (not shown), or a magnetic spring. Any of these springs 246a-b may be seized in order to limit upward travel of the ferrite block 224.

**Referring to** **Figures 1-7****,** in operation, the device 100 assumes two positions - a closed position 154 (as seen in Fig. 1) and an open position 156 (as seen in Figs. 4 and 7). In the closed position, the device 100 may be locked or unlocked. The closed position 154 of the device 100 appears in Figures 1 and 2.

In the closed position 154, unlocked, pressing the trigger 204 rotates the pivot jaw 202 towards the fixed jaw 132. The lower surface 239 of the T-shaped ferrite block 238 moves into contact with the U-shaped ferrite 310 of the fixed jaw 132, enclosing the channel 134. The closed position 154 is compact for carrying and storage but prevents the device 100 from receiving a wire for testing. Positioning the device 100 in the closed position 154 protects the working components from accidental damage. Locking the pivot joint 138 with the pivot joint lock 136 keeps the trigger 204 pressed inwardly and keeps the pivot jaw 202 and fixed jaw 132 in constant contact, even without a user gripping the device 100. When the device 100 is in the closed position 154 with no wire 158 contained within the jaw assembly 112, a user may press and hold the power button 126 to complete a calibration step for the device 100. Here, the LEDs 128a-b will glow green and the buzzer (not pictured) will sound for one second as the device 100 enters into "self-calibration mode." If calibration is unsuccessful one or both of the LEDs 128a-b will blink red, at which point the user must repeat the calibration step.

Unlocking the pivot joint 138 by moving the pivot joint lock 136 into an unlocked position out of the detent 220 permits transitioning from the closed position 154 to the open position 156. The open position 156 of the device 100 appears in Figure 3. In the open position 156, the trigger 204 is in an unpressed and deactivated state which keeps the pivot jaw 202 by virtue of a bias force provided by a spring (not shown) housed in the trigger 204. As a result, the channel 134 of the U-shaped ferrite 310 can receive a wire (not shown). In other words, positioning the device 100 in the open position 156 provides optimal clearance for inserting a wire 158 for testing.

In the open position 156, the pivot joint lock 136 remains in the unlocked position. The ears 238 of the T-shaped ferrite block 224 slide on to the lower stop shoulders 230, i.e., down to the bottom of the range of travel 250. The circuitry 318 of the device 100 is normally deactivated until the power button is utilized. However, pressing the power button 126 in the open position 156 will change the buzzer volume for the device 100.

To begin the wire testing process, the device 100 is in the open position 156 for placing a wire into the channel 134 of the U-shaped ferrite 310. Pressing the trigger 204 rotates the pivot joint 138 towards the fixed jaw 132. When the T-shaped ferrite block 224 contacts the U-shaped ferrite 310, the channel 134 is closed to complete the magnetic loop. The T-shaped ferrite block 224 slides away from the bottom of the range of travel as needed to ensure proper completion of the magnetic loop. In other words, the force of the springs 246a-b is overcome so that the radial ears 238 move upward away from the lower stop shoulders to ensure proper contact between the T-shaped ferrite block 224 and the U-shaped ferrite 310. Thus, the magnetic loop (not pictured) is effectively formed around the wire.

Pressing the trigger 204 can actuate switch 2 (SW2) 308, which is located under the PCB assembly 302 and activates the flashlight 130 to emit light through the valley 218 illuminating the area surrounding the wire 158 being tested. Maintaining the beam for a suitable period allows conducting the electrical current test, with typical durations ranging from five seconds to one minute. Pressing the trigger 204 multiple times will reset the beam's duration for extended usage. In another embodiment, the flashlight 130 is turned on with a switch or activation of the power button.

Securing the wire 158 within the ferrite block 224 and U-shaped ferrite 310 allows the user to press the power button 126 on the handle portion 102, activating the circuitry 318 of the device 100. Preferably, the lock 136 can be deployed into the detent 220 to allow for single hand operation. The magnetic loop of the T-shaped ferrite block 224 and U-shaped ferrite 310 surround the wire 158 to magnify and direct any magnetic field generated by current flowing through the wire to the Hall effect sensor 312. The circuitry 318 receives and process the signal from the Hall effect sensor 312. Based on the signal, the device 100 can determine the presence or absence of a current within the wire 158.

In an alternate embodiment, the device 100 is in the open position 156 for placing a wire into the channel 134 of the U-shaped ferrite 310. Pressing the trigger 204 rotates the pivot joint 138 towards the fixed jaw 132. When the T-shaped ferrite block 224 contacts the wire 158, the channel 134 is closed to complete the magnetic loop. The T-shaped ferrite block 224 slides away from the wire 158. In other words, the force of the springs 246a-b is overcome so that the radial ears 238 move upward away from the lower stop shoulders due to contact between the lower surface 239 of the ferrite block 224 and the wire 158 within the channel 134 of the U-shaped ferrite 310.

In another alternate embodiment, the pivot jaw 202 and the fixed jaw 132 are at rest in the closed position 154 and are held together by springs 246a-b. In this embodiment, actuation of the trigger 204 causes the pivot jaw 202 to move away from the fixed jaw 132 to receive a wire. Releasing the trigger 204 would then cause the pivot jaw 202 to move towards the fixed jaw 132 for testing.

As shown in Figure 7, the circuitry 318 utilizes the LEDs 128a-b on the handle portion 110 to provide information to the user. In one embodiment, there are a green indicator 128a and a red indicator 128b. In the context of the device 100 of the present invention, the green indicator 128a may indicate that a strong current has been detected in the wire 158, while the red indicator 128b may indicate that there is a weak or inconsistent current within the wire 158. If neither the green indicator 128a nor the red indicator 128b light up, there may be no current detected within the wire 158.

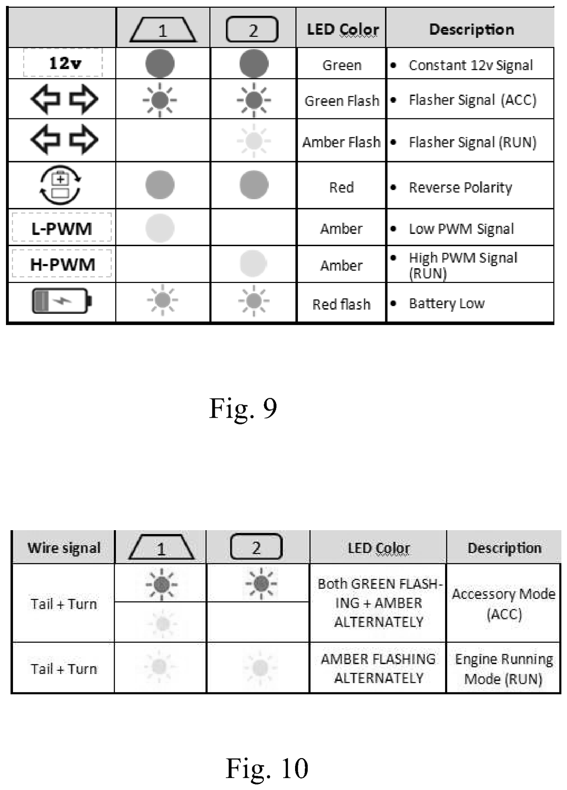

The LEDs 128a-b can flash or be consistently lit in varying colors or patterns to communicate the presence or absence of current in the wire. The LEDs 128a-b can also include a screen or other display for visually conveying whether current is present in the wire 158. The output can further indicate the magnitude of the current, enabling the user to assess electrical conditions during testing, as will be discussed in greater detail at Figures 9-10. Additionally, the buzzer may be used to indicate testing results or device function. As previously stated, the volume of the buzzer is adjustable.

Upon completion of testing, the user releases the trigger 204 which decompresses the spring (not shown) within the spring cavity 214 of the trigger 204 and biases the pivot jaw 202 away from the fixed jaw 132, returning the device 100 to the open position 156. The user removes the wire 158 from the channel 134 and either repeats the process to test additional wires or, returns the device 100 to the closed position 154 for storage. The signal may also indicate other desired metrics such as magnitude of the current, and the like. If no activation of the device 100 is performed for a suitable amount of time, the device 100 will automatically turn off due to the built-in "battery save mode."

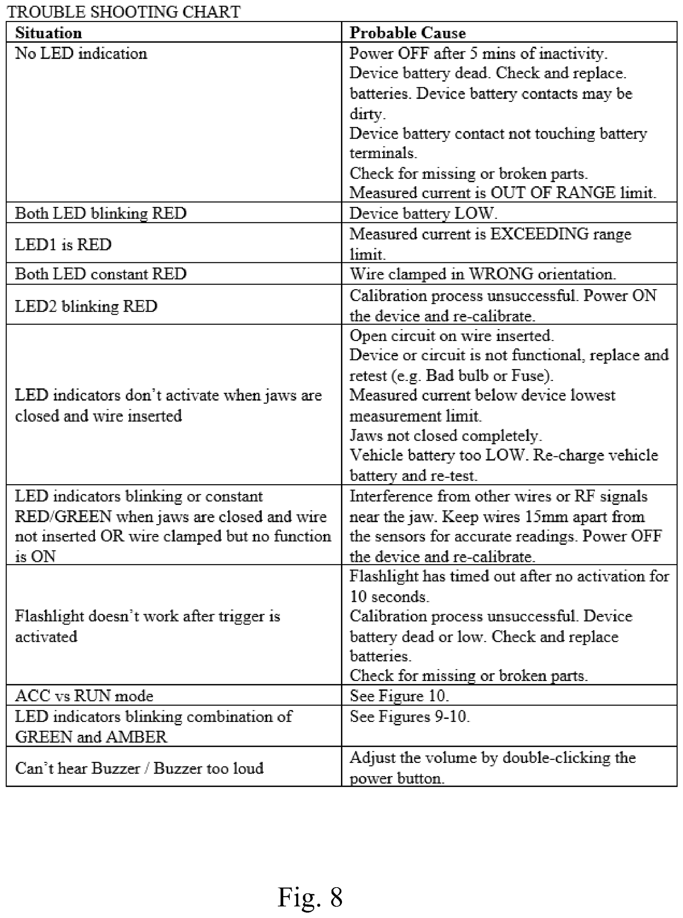

**Referring to** **Figure 8****,** a troubleshooting chart for operation of the device 100 is provided. Figure 8 illustrates a troubleshooting guide chart presenting common operational issues, corresponding causes, and recommended corrective actions for restoring proper function of the device 100.

For example, if both LEDs 128a-b are blinking red, the device 100 has low battery. If only LED 1, 128a is blinking red, the measured current is exceeding the range limit. If both LEDs 128a-b are constantly red, the wire is clamped in the wrong orientation. And, if only LED is blinking red, the calibration process was unsuccessful and the user must "power on" the device 100 and re-calibrate it.

**Referring to** **Figure 9****,** a chart is provided that illustrates LED configurations and the corresponding operational states of the device 100, including status conditions and responses visible to the user. Figure 9 shows that the LEDs 128a-b of the device 100 illuminate green, yellow, and/or red lights, in varying combinations of solid and flashing configurations, to represent the status of the current within the wire and to guide determination of subsequent steps in the test. The LEDs 128a-b present outputs for signals such as a constant 12-volt signal, which represents that a constant 12-volt current is present within the wire 158 under test. The LEDs 128a-b also present outputs representative of flasher signals, PWM signals, low battery conditions within the device, reversed polarity, or detection of tail and turn signals in accessory mode and/or with the engine operating.

**Referring to** **Figure 10****,** a chart is provided that illustrates LED indicator configurations associated with detection of tail and turn signals. The chart shows that the LEDs, 128a-b of the device 100 illuminate in specific flashing patterns to represent operating conditions of a vehicle circuit. When the device detects a tail and turn signal in accessory mode, LED 1, 128a and LED 2, 128b display both green flashing and amber flashing alternately, providing a clear visual indication of accessory operation. When the same signal is detected in engine running mode, LED 1, 128a and LED 2, 128b display amber flashing alternately, thereby distinguishing engine operation from accessory operation. These configurations allow a user to readily identify whether a tail and turn signal is present with the vehicle in accessory mode or engine running mode, thereby enhancing accuracy of testing and diagnosis.

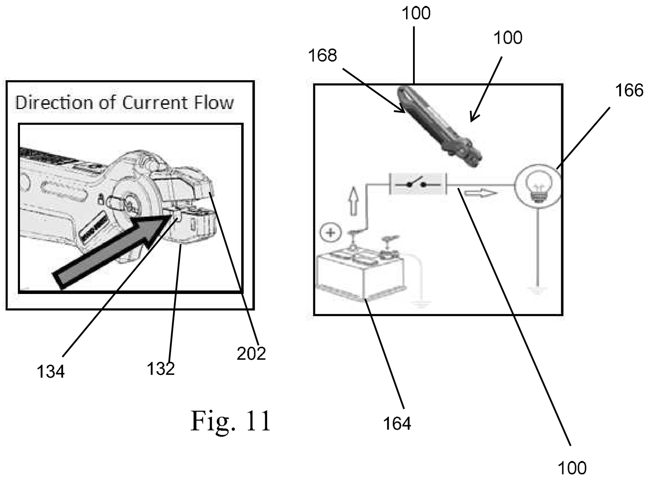

**Referring to** **Figure 11****,** the correct orientation of device 100 relative to a vehicle battery 164 and a tested device 166 is shown. In proper use, current flows from the vehicle battery 164 to the tested device 166, entering device 100 through the right side 168 and exiting through the left side 170. Accordingly, a user should position the right side 168 of device 100, while held in hand, to receive the wire 158 carrying current from the battery. The left side 170 of device 100, while in hand, should be positioned to receive the wire 158 carrying current toward the tested device. If a wire 158 is placed within the device 100 in the incorrect direction, a reverse polarity signal, as can be seen at Figures 9-10, will be displayed, indicating that the orientation of the device 100 must be reversed.

It will be appreciated by those of ordinary skill in the pertinent art that the functions of several elements may, in alternative embodiments, be carried out by fewer elements, or a single element. Similarly, in some embodiments, any functional element may perform fewer, or different, operations than those described with respect to the illustrated embodiment. Also, functional elements (e.g., springs, mounts, circuitry, switch and the like) shown as distinct or separate for purposes of illustration may be incorporated within other functional elements in a particular implementation.

Further, although the subject technology has been described with respect to the field of wire tester devices, it is envisioned that the subject technology would be equally applicable to other fields and applications such as electrical testing and diagnostics, cable testing, embedded systems and sensors, and the like.

All patents, patent applications and other references disclosed herein are hereby expressly incorporated in their entireties by reference. While the subject technology has been described with respect to preferred embodiments, those skilled in the art will readily appreciate that various changes and/or modifications can be made to the subject technology without departing from the spirit or scope of the invention as defined by the appended claims. For example, each claim may depend from any or all claims in a multiple dependent manner even though such has not been originally claimed.

## Claims

1. A testing device for non-invasively measuring current in a wire, the testing device comprising:
a body having: a handle portion for gripping by a user; and a distal fixed jaw extending from the handle portion and having a U-shaped ferrite defining a channel;
a trigger assembly rotatably coupled to the handle portion, the trigger assembly having: a distal pivot jaw opposing the fixed jaw; a trigger extending from the distal pivot jaw; and a ferrite block slidably mounted on the pivot jaw;
a Hall effect sensor coupled to at least one of the fixed jaw and trigger assembly; and
circuitry operatively connected to the Hall effect sensor for selective activation,
wherein:
in an open position, the trigger assembly is normally biased with the pivot jaw away from the fixed jaw so that the user can deploy a wire into the channel;
in a closed position, the trigger has been pulled by the user to rotate the pivot jaw towards the fixed jaw to: capture the wire in the channel; place the ferrite block towards the U-shaped ferrite to enclose the channel to create a magnetic loop surrounding the wire; and slide the ferrite block radially outward from an axis based on interaction with the U-shaped ferrite; and the circuitry is activated, the magnetic loop magnifies a magnetic field generated from current flowing through the wire to the Hall effect sensor so that the circuitry generates a signal indicative of the current based on a signal from the Hall effect sensor.

2. The testing device of claim 1, wherein the ferrite block further comprises radial ears to prevent the ferrite block from exiting the pivot jaw.

3. The testing device of claim 1, wherein the radial ears of the ferrite block interact with a lower stop shoulder at a bottom of a range of travel and wherein an upper surface of the ferrite block interacts with an upper stop surface at a top of a range of travel.

4. The testing device of claim 3, wherein the upper surface of the ferrite block and the upper stop surface further comprise at least one aligned spring recess to prevent lateral displacement of at least one spring.

5. The testing device of claim 1, wherein a lower surface of the ferrite block contacts the wire causing the ferrite block to slide radially outward from the axis.

6. The testing device of claim 1, wherein a user deploys a pivot joint lock into a hub detent to facilitate one handed operation of the device, and the current flowing through the wire runs substantially perpendicular to the magnetic field generated within the magnetic loop, the magnetic field intersecting a sensing plane of the Hall effect sensor and generating a signal in the circuitry substantially proportional to the change in magnetic flux induced by the current flowing through the wire, wherein the signal generated by the circuitry activates one or more LEDs positioned on the handle portion of the device, the one or more LEDs being configured to emit a blinking or color-changing light, display words or graphics on a screen, or generate an output indicative of the magnitude of the current flowing through the wire.

7. The testing device of claim 1, wherein activation of the trigger leads to activation of a flashlight located on the handle portion of the device which passes a focused beam of light through a valley on a top side of the pivot jaw, wherein the flashlight fades off after a suitable amount of time absent any additional activation of the trigger.

8. A non-invasive wire testing device for testing current in a wire, comprising:
a body having:
a handle portion for gripping by a user;
a distal jaw fixed on the handle portion, the distal jaw including a U-shaped ferrite;
a pivot jaw rotatably coupled to the handle portion, the pivot jaw including a ferrite block for selectively contacting the fixed jaw to enclose a channel, for receiving an wire on an axis within the channel when the pivot jaw and the fixed jaw are in a closed position; and
a Hall effect sensor coupled to the distal jaw,
wherein in the closed position, the ferrite block is configured to move against the U-shaped ferrite to form a magnetic loop around the wire, and the magnetic loop magnifies a magnetic field generated from current flowing through the wire to the Hall effect sensor for generating a signal indicative of the current.

9. The testing device of claim 8, wherein the ferrite block is biased against the U-shaped ferrite.

10. The testing device of claim 9, wherein one or more springs that are glued or otherwise secured to an upper stop surface and a top of the ferrite block for biasing against the ferrite block.

11. A device for non-invasively measuring current within a wire, the device comprising:
a body having:
a handle portion for gripping by a user, the handle portion including a power button and LEDs disposed thereon; and
a distal fixed jaw extending from the handle portion and having a U-shaped ferrite defining a channel;
a trigger assembly rotatably coupled to the handle portion, the trigger assembly comprising:
a distal pivot jaw opposing the fixed jaw;
a trigger extending from the distal pivot jaw;
a ferrite block slidably mounted on the pivot jaw; and
a pivot jaw lock;
a Hall effect sensor coupled to one of the fixed jaw and the trigger assembly; and
circuitry operatively connected to the Hall effect sensor for selective activation;
wherein:
in an open position, rotating the pivot jaw lock into an unlocked position releases the trigger, biasing the pivot jaw away from the fixed jaw for receiving the wire; and
in a closed position, the user:
positions the wire within the channel,
presses the trigger biasing the pivot jaw toward the fixed jaw to contact the ferrite block with the U-shaped ferrite, forming a magnetic loop surrounding the wire,
and
receives an output from the LEDs indicative of the signal communicated by the circuitry from the Hall effect sensor.

12. The device of claim 11, wherein a first ferrite is a U-shaped ferrite defining a channel and a second ferrite is a ferrite block slidably mounted on the pivot jaw, wherein the pivot jaw locks via a pivot jaw lock.

13. The device of claim 11, wherein the first ferrite is slidably mounted on the pivot jaw and the second ferrite is mounted on the fixed jaw.
